# EUROPÄISCHE PATENTSCHRIFT

(11) **EP 0 561 146 B1**
(45) Veröffentlichungstag und Bekanntmachung des Hinweises auf die Patenterteilung: **12.04.2000**
(21) Anmeldenummer: 93101911.1
(22) Anmeldetag: 08.02.1993
(51) Int. Cl.: G01R 31/00

(54) **Verfahren zur Ermittlung von IST-Auslösekennlinien**
Method for determining switching characteristics
Méthode de détermination de caractéristique de déclenchage

(30) Priorität: 18.03.1992 DE 4208613
(43) Veröffentlichungstag der Anmeldung: 22.09.1993
(73) Patentinhaber: ASEA BROWN BOVERI AG, 5400 Baden (CH)
(72) Erfinder: Schutter, Jan, CH-5417 Untersiggenthal (CH); Wiederkehr, Martin, CH-5268 Eiken (CH)
(74) Vertreter: Kaiser, Helmut, Dr.

(56) Entgegenhaltungen:
- DE-A- 2 827 263
- IEEE TRANS. POWER APPAR. & SYST., Bd. pas-96, Nr. 4, Juli 1977, Seiten 1376-1381, XP002007583 SWIFT ET AL.: "an automated testing system fot distance relays"

## Beschreibung

Die Erfindung geht aus von einem Verfahren zur Ermittlung von Ist-Auslösekennlinien gemäss dem Oberbegriff des Anspruchs 1.

### Stand der Technik

Ein solches Verfahren ist z.B. aus IEEE Transactions on Power Apparatus and Systems, Vol PAS-96, no. 4, July/August 1997, pages 1376-1381 bekannt.

Es sind Prüfgeräte bekannt für die Funktionsprüfung und zur Kontrolle der Ansprech- und Auslösekennlinien von verschiedenen Schutzrelais, insbesondere Frequenzrelais, Distanzrelais, Richtungsrelais und Leistungsrelais. Derartige Prüfgeräte erlauben dynamische oder statische Prüfungen mit wählbaren Strom-, Spannungs- und Winkel- bzw. Impedanzparametern in einem weiten Bereich. Die Prüfgeräte sind programmierbar ausgeführt, so dass der Anwender die Prüfabläufe selber bestimmen kann, wenn er nicht auf bestehende Prüfprogramme zurückgreifen will.

Bei diesen bekannten Prüfgeräten kann ein externer Rechner benutzt werden, um Berechnungen von theoretischen Auslösekennlinien vorzunehmen und diese theoretischen Kennlinien mit den gemessenen Ist-Auslösekennlinien zu vergleichen.

Bei der Messung einer Auslösekennlinie eines Schutzgerätes, beispielsweise eines Distanzrelais, in einer Impedanzebene wird entweder der Betrag der Impedanz konstant gehalten und der Winkel variiert oder der Winkel wird konstant gehalten und der Betrag der Impedanz variiert. Bei diesen Messverfahren kann es vorkommen, dass die Linie, entlang der gemessen wird, häufig ist dies eine Suchgerade, sich mit der Ist-Auslösekennlinie in einem sehr spitzen Winkel schneidet, so dass keine klar definierten Schnittpunkte entstehen. Die Bestimmung der Ist-Auslösekennlinie in diesem Bereich kann nur vergleichsweise ungenau erfolgen, zudem wird eine vergleichsweise lange Zeit für diese mit Hilfe von Iterationsverfahren durchgeführten Messungen benötigt. Bei einem weiteren Messverfahren wird über die Impedanzebene ein Raster von Messpunkten gelegt. Aus diesen sehr zeitaufwendigen Messungen kann die Ist-Auslösekennlinie in grober Näherung bestimmt werden.

Wahrend der jeweiligen Messungen ist das zu prüfende Relais vom Netz abgekuppelt und kann seine Schutzaufgaben nicht wahrnehmen. Zeitaufwendigere, ungenaue Messungen verlängern die Zeit, während der der Schutz nicht voll einsatzbereit sein kann, unnötig.

### Darstellung der Erfindung

Hier will die Erfindung Abhilfe schaffen. Die Erfindung, wie sie im unabhängigen Anspruch gekennzeichnet ist, löst die Aufgabe, ein Verfahren zur Ermittlung von Auslösekennlinien zu schaffen, welches besonders schnell und genau arbeitet.

Die durch die Erfindung erreichten Vorteile sind darin zu sehen, dass die Verfügbarkeit der zu prüfenden Schutzeinrichtungen wesentlich verbessert wird. Ferner wirkt es sich besonders vorteilhaft aus, dass stets genau definierte Schnittpunkte mit der Auslösekennlinie bestimmt werden.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### Kurze Beschreibung der Zeichnung

Es zeigen:
- Fig. 1: ein Blockschaltbild des erfindungsgemässen Verfahrens,
- Fig. 2: eine Detailskizze und
- Fig. 3: eine weitere Detailskizze zur Verdeutlichung von Verfahrensschritten.

Bei allen Figuren sind gleich wirkende Elemente mit gleichen Bezugszeichen versehen.

### Wege zur Ausführung der Erfindung

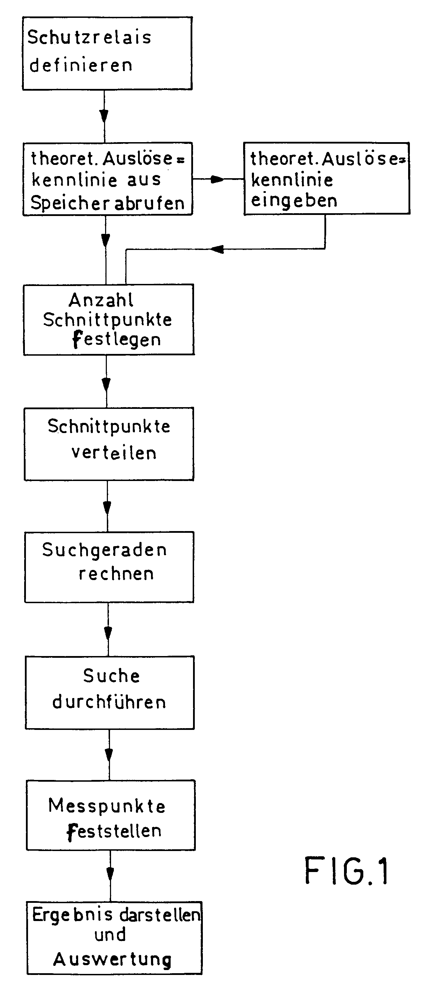

Fig. 1 zeigt ein Blockschaltbild mit den wichtigsten Verfahrensschritten zur Ermittlung von Ist-Auslösekennlinien von Schutzrelais. Dabei ist es unerheblich, welcher Typ von Schutzrelais untersucht werden soll. Für diese Untersuchungen wird eines der bekannten Prüfgeräte eingesetzt, welches hier jedoch nicht näher beschrieben werden soll. Nachdem zuerst der Typ des Schutzrelais festgelegt wurde, etwa durch das eingesetzte, mit dem Schutzrelais verbundene Prüfgerät, wird als nächstes die theoretische Auslösekennlinie aus dem Speicher des Prüfgeräts abgerufen und in der Regel in einem Display sichtbar gemacht. Ist für das betreffende Schutzrelais keine Auslösekennlinie im Speicher vorhanden, so wird mittels einer mit dem Prüfgerät verbundenen Eingabeeinheit, beruhend auf den Einstelldaten des betreffenden Schutzrelais, eine theoretische Auslösekennlinie ermittelt und danach eingespeist. Als Eingabeeinheit wird vorteilhaft ein Personalcomputer verwendet und dessen Bildschirm wird als Display verwendet. In der Regel werden die theoretischen Auslösekennlinien auf diesem Display sichtbar gemacht.

Anschliessend wird die Anzahl der Schnittpunkte einer Suchgeraden mit der theoretischen Auslösekennlinie festgelegt. Je grösser die Anzahl dieser Schnittpunkte gewählt wird, desto genauer kann die Ist- Auslösekennlinie bestimmt werden. Wird hier eine grosse Genauigkeit verlangt, so steigt entsprechend auch der Zeitaufwand für die Durchführung der Untersuchung. Die Schnittpunkte werden durch die Eingabeeinheit gleichmässig auf der theoretischen Auslösekurve verteilt. Durch einen in der Eingabeeinheit plazierten Rechner wird zu jedem der Schnittpunkte eine Suchgerade berechnet, welche die theoretische Auslösekennlinie schneidet. Danach wird die eigentliche Suche durchgeführt, wobei die Schnittpunkte nacheinander für die Bestimmung der ihnen jeweils entsprechenden Messpunkte auf der Ist-Auslösekennlinie herangezogen werden. Nach dem Abschluss der Untersuchungen wird das Ergebnis dargestellt, vorzugsweise auf einem Display. Die Ist-Auslösekennlinie wird auf der Basis der bestimmten Messpunkte berechnet und dargestellt. Anschliessend wird diese Ist-Auslösekennlinie mit der theoretischen Auslösekennlinie verglichen. Eine Auswertung zeigt, ob das untersuchte Schutzrelais in einem vorgegebenen Bereich seine Funktion zuverlässig innerhalb eines vorgegebenen Toleranzbereichs erfüllt. Diese Auswertung kann auch automatisch durchgeführt werden.

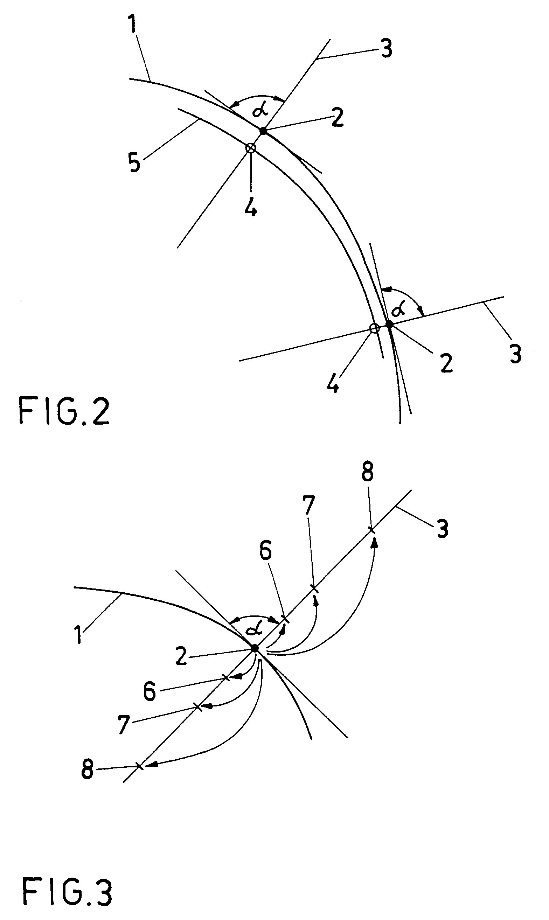

Fig. 2 zeigt einen Ausschnitt aus einer Impedanzebene eines Schutzrelais mit einem Teil einer theoretischen Auslösekennlinie 1. Auf dieser Auslösekennlinie 1 sind zwei Schnittpunkte 2 dargestellt, die durch die Eingabeeinheit festgelegt worden sind. Ein in der Eingabeeinheit implementierter Algorithmus rechnet nun Suchgeraden 3 aus, welche die theoretische Auslösekennlinie 1 im jeweiligen Schnittpunkt 2 unter einem Winkel α schneiden. Um einen klar definierten Schnittpunkt 2 zu erreichen, wird der Winkel α in einem Bereich von etwa 60° bis 120° gewählt. Als besonders vorteilhaft hat sich ein Winkel α von 90° erwiesen. Auf jeder dieser Suchgeraden wird nun die Suche nach Messpunkten 4 durchgeführt, die auf der Ist-Auslösekennlinie 5 liegen.

Das Vorgehen bei dieser Suche wird anhand der Fig. 3 beschrieben. Ausgehend vom Schnittpunkt 2 der Suchgeraden 3 mit der theoretischen Auslösekurve 1 wird beidseitig auf der Suchgeraden 3 mit einer vorwählbaren Abweichung eine erste Messung in den Punkten 6 auf der Suchgeraden 3 durchgeführt. Wird in den beiden Punkten 6 keine Auslösung des Schutzrelais festgestellt, so wird davon ausgegangen, dass im Bereich dazwischen keine Auslösung stattfindet und die Messgrenze also nicht in diesem Bereich liegt. Deswegen wird eine zweite Messung mit verdoppelter Abweichung in den Punkten 7 durchgeführt. Wird in beiden Punkten 6 Auslösung festgestellt, so wird davon ausgegangen, dass im ganzen Bereich dazwischen Auslösung stattfindet und die Messgrenze ebenfalls nicht in diesem Bereich liegt. Es wird in diesem Fall ebenfalls eine zweite Messung in 7 durchgeführt. Wird in den beiden Punkten 7 wieder gleiches Ergebnis festgestellt (zweimal keine Auslösung oder zweimal Auslösung), so wird die Abweichung wieder verdoppelt und in den Punkten 8 gemessen. Dieses Erweitern der Abweichung wird entweder weitergeführt, bis a) die Messergebnisse bei einem Punktepaar unterschiedlich sind und sich somit die Messgrenze innerhalb des letzten Punktepaares befindet, oder bis b) eine vorgegebene Abweichung erreicht wird, ohne dass unterschiedliche Messergebnisse festgestellt wurden. Im Falle a) wird jetzt iterativ die genaue Messgrenze zwischen dem letzten Punktepaar gesucht. Die gefundene Messgrenze entspricht dann einem Messpunkt 4 auf der Ist-Auslösekennlinie. Im Falle b) wird die Messung abgebrochen, da das Schutzrelais in diesem Auslösebereich nicht zufriedenstellend arbeitet und deshalb überholt oder ersetzt werden muss.

In Fig. 2 sind Messpunkte 4 dargestellt, also Punkte in denen das Schutzrelais bei der entsprechenden Messung ausgelöst hat. Diese Messpunkte 4 werden benutzt, um die Ist-Auslösekennlinie 5 zu bestimmen. Wenn, wie hier gezeigt, die theoretische Auslösekennlinie 1 und die Ist-Auslösekennlinie 5 vergleichsweise nahe beieinander und im tolerierbaren Arbeitsbereich des jeweiligen Schutzrelais liegen, ergibt die Auswertung der Resultate, dass das betreffende Schutzrelais zufriedenstellend arbeitet, und dass es weiter im Einsatz bleiben und die Betriebssicherheit des zu schützenden Netzbereichs sicherstellen kann. Die Darstellung dieser Resultate auf einem Display erleichtert deren Beurteilung.

Das beschriebene Messverfahren arbeitet sehr rasch und zuverlässig, da eindeutige Schnittpunkte 2 auf der theoretischen Kennlinie als Ausgangspunkte für die Messung bestimmt werden. Die Zeitspanne, für welche das zu untersuchende Schutzrelais für die Messung ausser Betrieb gesetzt werden muss, kann deshalb vorteilhaft klein gehalten werden, so dass die Reduzierung der Verfügbarkeit der zu untersuchenden Schutzrelais kaum ins Gewicht fällt. Der gesamte Messvorgang kann auch vollständig automatisiert werden, um so noch schneller die gesuchte Ist-Auslösekennlinie 5 zu erhalten.

### Bezeichnungsliste

- 1: theoretische Auslösekennlinie
- 2: Schnittpunkt
- 3: Suchgerade
- 4: Messpunkt
- 5: Ist-Auslösekennlinie
- 6,7,8: Punktepaare

## Patentansprüche

1. Verfahren zur Ermittlung von Ist-Auslösekennlinien von Schutzrelais mittels eines Prüfgerätes, bei welchem die Prüfparameter mittels einer Eingabeeinheit in das Prüfgerät eingegeben werden, dadurch gekennzeichnet,
- dass eine theoretische Auslösekennlinie (1) des jeweiligen Schutzrelais im Prüfgerät gespeichert wird, und
- dass jeder Messpunkt (4) der Ist-Auslösekennlinie (5) auf einer Suchgeraden (3), von einem Schnittpunkt (2) der Suchgeraden (3) mit der theoretischen Auslösekennlinie (1) ausgehend, bestimmt wird und
- dass die Suchgerade (3) die theoretische Auslösekennlinie (1) unter einem Winkel (α) schneidet, wobei der Winkel (α) in einem Bereich von 60° bis 120° liegt, vorzugsweise jedoch 90° beträgt.

2. Verfahren nach Anspruch 1, dadurch gekennzeichnet,
- dass ausgehend von dem jeweiligen Schnittpunkt (2) beidseitig auf der Suchgeraden (3) mit einer vorwählbaren Abweichung eine erste Messung durchgeführt wird,
- dass danach, wenn keine Auslösung des Schutzrelais feststellbar ist, die Abweichung verdoppelt wird und damit eine zweite Messung durchgeführt wird,
- dass danach, wenn nochmals keine Auslösung des Schutzrelais feststellbar ist, dieses Vorgehen weitergeführt wird bis zu einer vorgegebenen relativen Abweichung, und dass danach die Messung für diesen Schnittpunkt (2) abgebrochen wird, und
- dass, sobald eine Auslösung des Schutzrelais festellbar ist, im Bereich zwischen der letzten und der vorletzten Abweichung iterativ der entsprechende Messpunkt (4) gesucht wird.

3. Verfahren nach Anspruch 1, dadurch gekennzeichnet,
- dass die theoretische Auslösekennlinie (1) des jeweiligen Schutzrelais entweder gesamthaft eingegeben wird oder in der Eingabeeinheit aus den Einstelldaten des Schutzrelais ermittelt und danach in das Prüfgerät eingespeist wird.

4. Verfahren nach Anspruch 2, dadurch gekennzeichnet,
- dass die der gewünschten Anzahl von Messpunkten (4) entsprechende Anzahl von Schnittpunkten (2) gleichmässig auf der theoretischen Auslösekennlinie (1) verteilt wird, wobei die Eingabeeinheit diese Verteilung vornimmt, und
- dass die Schnittpunkte (2) nacheinander für die Bestimmung der Messpunkte (4) herangezogen werden.

5. Verfahren nach Anspruch 4, dadurch gekennzeichnet,
- dass die theoretische Auslösekennlinie (1), die Schnittpunkte (2) und die Messpunkte (4) auf einem der Eingabeeinheit zugeordneten Display sichtbar gemacht werden.

6. Verfahren nach einem der Ansprüche 1 bis 5, dadurch gekennzeichnet,
- dass die Eingabeeinheit aufgrund der ermittelten Messpunkte (4) die Ist-Auslösekennlinie (5) bestimmt, und
- dass diese Ist-Auslösekennlinie (5) auf einem der Eingabeeinheit zugeordneten Display sichtbar gemacht wird.

7. Verfahren nach Anspruch 1, dadurch gekennzeichnet,
- dass als Eingabeeinheit ein Personalcomputer vorgesehen ist.

## Claims

1. Method for determining actual tripping characteristics of protective relays by means of a test apparatus in which the test parameters are input into the test apparatus by means of an input unit, characterized in that
- a theoretical tripping characteristic (1) of the respective protective relay is stored in the test apparatus, and
- each measurement point (4) of the actual tripping characteristic (5) on a locating straight line (3) is determined starting from a point (2) of intersection of the locating straight line (3) with the theoretical tripping characteristic (1), and
- the locating straight line (3) intersects the theoretical tripping characteristic (1) at an angle (α) which is situated in a range from 60° to 120°, but preferably is 90°.

2. Method according to Claim 1, characterized in that
- starting from the respective point (2) of intersection a first measurement is carried out on both sides on the locating straight line (3) with a preselectable deviation, and
- thereafter, if no tripping of the protective relay can be established, the deviation is doubled and a second measurement is carried out thereby,
- thereafter, if once again no tripping of the protective relay can be established this process is continued up to a prescribed relative deviation, and thereafter the measurement for this point (2) of intersection is broken off, and
- as soon as it is possible to establish a tripping of the protective relay the corresponding measurement point (4) is sought iteratively in the area between the last and the second-last deviation.

3. Method according to Claim 1, characterized in that
- the theoretical tripping characteristic (1) of the respective protective relay is input either as a whole or determined in the input unit from the setting data of the protective relay and thereafter fed into the test apparatus.

4. Method according to Claim 2, characterized in that
- the number of points (2) of intersection which corresponds to the desired number of measurement points (4) is distributed uniformly on the theoretical tripping characteristic (1), the input unit undertaking this distribution, and
- the points (2) of intersection are used sequentially to determine the measurement points (4).

5. Method according to Claim 4, characterized in that
- the theoretical tripping characteristic (1), the points (2) of intersection and the measurement points (4) are visualized on a display assigned to the input unit.

6. Method according to one of Claims 1 to 5, characterized in that
- the input unit determines the actual tripping characteristic (5) on the basis of the measurement points (4) determined, and
- this actual tripping characteristic (5) is visualized on a display assigned to the input unit.

7. Method according to Claim 1, characterized in that
- a personal computer is provided as input unit.

## Revendications

1. Méthode de détermination des caractéristiques de déclenchement réelles de relais de protection au moyen d'un appareil de test, avec laquelle les paramètres de contrôle sont saisis dans l'appareil de test au moyen d'une unité de saisie, caractérisée par le fait
- qu'une caractéristique de déclenchement théorique (1) des différents relais de protection est mémorisée dans l'appareil de test, et
- que chaque point de mesure (4) de la caractéristique de déclenchement réelle (5) est déterminé sur une droite de recherche (3) en partant d'un point d'intersection (2) de la droite de recherche (3) avec la caractéristique de déclenchement théorique (1), et
- que la droite de recherche (3) coupe la caractéristique de déclenchement théorique (1) sous un angle (α), l'angle (α) étant compris entre 60° et 120°, de préférence égal à 90°.

2. Méthode selon la revendication 1, caractérisée par le fait
- qu'une première mesure est effectuée avec un écart prédéfini des deux côtés de la droite de recherche (3) en partant du point d'intersection (2) correspondant,
- qu'après celle-ci, si aucun déclenchement du relais de protection n'est constaté, l'écart est doublé et une seconde mesure est ensuite effectuée avec celui-ci,
- qu'après celle-ci, si aucun déclenchement du relais de protection n'est constaté là non plus, ce procédé est répété jusqu'à atteindre un écart relatif donné, et qu'ensuite la mesure pour ce point d'intersection (2) est interrompue, et
- que dès qu'un déclenchement du relais de protection est constaté, le point de mesure (4) correspondant est recherché par itération entre le dernier et l'avant-dernier écart.

3. Méthode selon la revendication 1, caractérisée par le fait
- que la caractéristique de déclenchement théorique (1) des différents relais de protection est soit saisie en globalité, soit déterminée dans l'unité de saisie à partie des données de réglage du relais de protection et chargée ensuite dans l'appareil de test.

4. Méthode selon la revendication 2, caractérisée par le fait
- que le nombre de points d'intersection (2) correspondant au nombre souhaité de points de mesure (4) est réparti régulièrement sur la caractéristique de déclenchement théorique (1), cette répartition étant effectuée par l'unité de saisie, et
- que les points d'intersection (2) sont utilisés l'un après l'autre pour déterminer les points de mesure (4).

5. Méthode selon la revendication 4, caractérisée par le fait
- que la caractéristique de déclenchement théorique (1), les points d' intersection (2) et les points de mesure (4) sont visualisés sur un dispositif d'affichage associé à l'unité de saisie.

6. Méthode selon l'une des revendications 1 à 5, caractérisée par le fait
- que l'unité de saisie détermine la caractéristique de déclenchement réelle (5) sur la base des points de mesure (4) déterminés, et
- que cette caractéristique de déclenchement réelle (5) est visualisée sur un dispositif d'affichage associé à l'unité de saisie.

7. Méthode selon la revendication 1, caractérisée par le fait
- que l'unité de saisie prévue est un ordinateur personnel.
